(19) Europäisches Patentamt
European Patent Office
Office européen des brevets

(11)  EP 2 622 386 B1

(12)  FASCICULE DE BREVET EUROPEEN

(45) Date de publication et mention
de la délivrance du brevet:
04.05.2022  Bulletin 2022/18

(21) Numéro de dépôt: 11773086.1

(22) Date de dépôt: 14.09.2011

(51) Classification Internationale des Brevets (IPC):
*G01V 99/00* $^{(2009.01)}$

(52) Classification Coopérative des Brevets (CPC):
G01V 99/00

(86) Numéro de dépôt international:
PCT/FR2011/052111

(87) Numéro de publication internationale:
WO 2012/045937 (12.04.2012 Gazette 2012/15)

(54) **SIMULATION DE PHENOMENE GEOLOGIQUE**

SIMULATION EINES GEOLOGISCHEN PHÄNOMENS

SIMULATION OF A GEOLOGICAL PHENOMENON

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  27.09.2010  FR 1057751

(43) Date de publication de la demande:
07.08.2013  Bulletin 2013/32

(73) Titulaire: **TOTAL SE**
**92400 Courbevoie (FR)**

(72) Inventeur: **MASSONNAT, Gérard**
**F-64000 Pau (FR)**

(74) Mandataire: **Plasseraud IP**
**66, rue de la Chaussée d'Antin**
**75440 Paris Cedex 09 (FR)**

(56) Documents cités:
**US-A1- 2002 120 429      US-A1- 2007 156 341**
**US-A1- 2009 157 320      US-B1- 6 205 402**
**US-B1- 6 480 790      US-B2- 7 286 937**

EP 2 622 386 B1

**Description**

L'invention se rapporte au domaine de la simulation de phénomène géologique pour l'étude du sous-sol.

L'invention concerne la simulation d'un phénomène géologique de karstification.

Il est connu de modéliser une région géologique de façon statique, en utilisant des observations notamment géologiques et sismiques. En cas de forage d'un puits, des données mesurées via le puits, dite données puits, peuvent être utilisées pour ajuster a posteriori le modèle de la région, en suivant une démarche d'inversion. Toutefois, cette approche traditionnelle est limitée en ce qu'elle de reproduit pas de façon dynamique les processus géologiques et hydrologiques conduisant à la formation de la région géologique, et en ce que l'ajustement du modèle aux données puits peut être relativement complexe et parfois instable.

Il est également connu de simuler le ou les phénomènes géologiques (« forward modeling » en anglais) ayant conduit à la formation de la région géologique, à partir d'un modèle de la région. Par exemple, l'article de O.Jaquet et al., « Stochastic discrete model of karstic networks », Advances in Water Resources 27 (2004), 751-760, décrit un procédé de modélisation de phénomènes de karstification basé sur une approche stochastique.

Des exemples possibles et des modes de réalisation de l'art antérieur peuvent être trouvés dans les documents US 2002/120429 A1, U 6 205 402 B1, US 6 480 790 B1, US 2007/156341 A1.

Typiquement, il est mis fin à la simulation de façon qualitative, ce qui peut conduire à des résultats relativement éloignés de la réalité géologique.

La présente invention vient améliorer la situation. Selon un premier aspect, il est proposé un procédé de simulation d'un phénomène géologique de karstification ayant conduit à la formation d'une région géologique selon la revendication 1.

Ainsi, l'observation est utilisée pour contrôler un ou plusieurs paramètres de la simulation.

La façon dont le modèle de la région géologique évolue est donc fonction du degré de similitude entre l'observation reçue à l'étape b/ et l'estimation obtenue à l'étape e/.

Les étapes c/ et e/ de définition d'une zone pertinente et d'estimation du paramètre pour cette zone pertinente permettent cette utilisation de l'observation dans le cadre du procédé de modélisation.

Les étapes d/, e/, f/ peuvent être répétées régulièrement tant que l'observation et l'estimation du paramètre donné ne sont pas suffisamment proches.

On peut par exemple se contenter de laisser les paramètres de simulation inchangés tant que les résultats des comparaisons de l'étape f/ montrent que l'observation et l'estimation du paramètre donné ne sont pas suffisamment proches, et de mettre fin à la simulation dans la cas contraire. La simulation permet de faire évoluer le modèle de la région géologique, et ce jusqu'à ce que ce modèle corresponde à l'observation, tout en évitant l'instabilité et la complexité des méthodes d'inversions.

On évite également de mettre fin à la simulation de manière qualitative, ce qui permet de caler au mieux aux mesures reçues, et donc d'améliorer la qualité de la simulation.

Selon un autre exemple, on peut amplifier ou limiter les effets de la simulation selon le résultat de la comparaison de l'étape f/. Par exemple, si cette comparaison montre que l'estimation obtenue à l'étape e/ est encore très différente de l'observation reçue à l'étape b/, on peut modifier un paramètre de simulation de façon à accentuer les effets de la simulation sur le modèle. Les étapes d/ à g/ peuvent être répétées régulièrement, de sorte qu'au fur et à mesure que l'estimation obtenue à l'étape e/ se rapproche de l'observation reçue à l'étape b/, on modifie un paramètre de simulation de façon à atténuer les effets de la simulation sur le modèle. On peut prévoir de mettre fin à la simulation lorsque le paramètre de simulation atteint un certain seuil prédéterminé.

Le paramètre de simulation peut par exemple comprendre une fréquence de cycles de simulation, un nombre de cycles de simulation, un nombre de particules à introduire par cycle, une vitesse de sédimentation, un index de karstification, ou autre.

A l'étape g/, la simulation est adaptée dans ses effets pour seulement une zone du modèle. Dans ce dernier cas, l'adaptation des effets de la simulation peut, du fait de son caractère local, mieux correspondre à la réalité de la région géologique.

On peut en particulier définir pour une observation une zone de représentativité, par exemple la zone pertinente, et prévoir que l'adaptation de la simulation de l'étape g/ ne concerne que cette zone de représentativité. La zone de représentativité peut être différente de la zone pertinente : par exemple, la zone de représentativité peut comprendre la zone pertinente.

On peut considérer que l'observation et l'estimation du paramètre donné sont suffisamment proches lorsque la différence ou le ratio entre l'observation et l'estimation du paramètre donné est inférieur à un seuil prédéterminé. De manière générale, l'invention n'est pas limitée par le type de test mis en œuvre lors de l'étape f/ de comparaison.

L'invention n'est pas non plus limitée par l'ordre donné ci-dessus des étapes a/ à g/. Par exemple, on peut effectuer l'étape b/ préalablement à l'étape a/, ou bien encore effectuer l'étape c/ en même temps que l'étape d/ de simulation.

On peut prévoir d'effectuer une ou plusieurs observations, d'un ou plusieurs paramètres. Pour obtenir la ou les observations, on effectue une ou des mesures de ce ou ces paramètres, par exemple en profitant d'installations de puits.

Avantageusement, lorsque plusieurs observations sont reçues, on effectue les étapes c/, e/ et f/ autant de fois qu'il y a d'observations. On dispose ainsi de plusieurs résultats de comparaison, c'est-à-dire de davantage d'informations pour choisir comment à l'étape g/ adapter les effets de la simulation de façon plus appropriée. Par exemple, il est mis fin à la simulation seulement si un certain nombre de comparaisons montrent un degré de similitude suffisant entre observations et estimations correspondantes.

Avantageusement, on peut associer à chaque observation une zone de représentativité, et, pour chaque zone de représentativité, modifier le paramètre de simulation correspondant à cette zone selon le résultat de la comparaison entre l'observation correspondant à cette zone et l'estimation correspondant à cette zone. Ainsi, on adapte la simulation zone par zone. Par exemple, on met fin à la simulation dans les zones où le calage est atteint, tout en continuant le processus dans les autres zones pour lesquelles la calibration est encore insuffisante. On détermine donc localement, en fonction des observations, quand adapter la simulation, ce qui peut permettre de mieux caler à l'ensemble des observations.

Ainsi, on peut par exemple partager le modèle en autant de parties que d'observations, et pour chaque partie mettre fin à la simulation lorsque le paramètre estimé et le paramètre simulé correspondant sont suffisamment proches, indépendamment des autres parties du modèle.

Avantageusement, pour au moins une observation, on peut définir au moins une zone de représentativité supplémentaire. Lors de l'étape g/, selon les résultats de la comparaison de l'étape f/, on peut adapter les effets de la simulation sur la zone de représentativité et sur cette au moins une zone de représentativité supplémentaire.

Par exemple, on associe un paramètre de simulation supplémentaire à chaque zone de représentativité supplémentaire. A l'étape g/, à la fois le paramètre de simulation associé à la zone de représentativité et chaque paramètre de simulation supplémentaire sont susceptibles d'être modifiés, selon les résultats de la comparaison de l'étape f/.

Par exemple, si l'observation et l'estimation correspondante sont suffisamment proches, on met fin à la simulation pour la zone de représentativité correspondante, et pour chacune des zones de représentativité supplémentaires autour de cette zone de représentativité, on poursuit la simulation de façon à ce que les effets de la simulation soient atténués. On peut choisir de plus ou moins atténuer les effets de la simulation sur une zone selon la proximité de la zone avec la zone de représentativité.

Par exemple, à une observation sont associées trois zones concentriques. Lorsque l'estimation obtenue à l'étape e/ est suffisamment proche de l'observation, on met fin à la simulation pour la zone centrale, on poursuit la simulation sur la zone périphérique en limitant de 25% un paramètre de vitesse de sédimentation, et on poursuit la simulation pour la zone intermédiaire en limitant de 50% ce paramètre de vitesse de sédimentation.

Les effets de la simulation sont ainsi plus ou moins atténués, ou plus ou moins accentués, selon les zones, ce qui permet un effet de lissage. On évite ainsi d'obtenir des images où les zones de représentativité apparaissent de façon contrastée.

On peut prévoir que les valeurs des paramètres de simulation associés aux zones de représentativité soient susceptibles de prendre plusieurs valeurs, en fonction du résultat de la comparaison de l'étape f/. Ainsi, au fur et à mesure que le paramètre estimé se rapproche du paramètre observé, on atténue dynamiquement les effets de la simulation.

Bien entendu, l'invention n'est en rien limitée par cet effet de lissage.

Avantageusement, une étape de mise à l'échelle des résultats courants de la simulation est effectuée lors de l'estimation de l'étape e/. On utilise un outil du type solveur de pression. On peut également effectuer un moyennage pertinent de paramètres du type perméabilité, ou autre.

L'invention n'est en rien limitée par cette étape de mise à l'échelle, en particulier si par exemple la zone pertinente est du même ordre de grandeur qu'une maille du modèle géologique.

Le modèle de la région géologique comprend un réseau maillé.

Lors de l'étape de simulation, on simule des déplacements stochastiques dans le maillage de particules correspondant à de l'eau

Selon un autre aspect, l'invention a pour objet un produit programme d'ordinateur de simulation d'un phénomène géologique de karstification ayant conduit à la formation d'une région géologique selon la revendication 7.

Selon encore un autre aspect, l'invention a pour objet un dispositif de simulation d'un phénomène géologique de karstification ayant conduit à la formation d'une région géologique selon la revendication 8.

Le dispositif de simulation peut comprendre par exemple un ordinateur, une unité centrale, un processeur, ou un calculateur dédié à la simulation de phénomènes géologiques, ou autre.

La figure 1 montre un exemple de zone karstique.

La figure 2 est un organigramme d'un exemple de procédé de simulation selon un mode de réalisation de l'invention.

La figure 3 montre un exemple d'image susceptible d'être obtenue par un procédé selon un mode de réalisation de l'invention.

La figure 4 est un organigramme d'un exemple de procédé de simulation selon un autre mode de réalisation de l'invention.

La figure 5 montre un exemple de modèle géologique segmenté en différentes zones pour illustrer le mode de réalisation de la figure 4.

La figure 6 montre un exemple de dispositif de simulation, selon un mode de réalisation de l'invention.

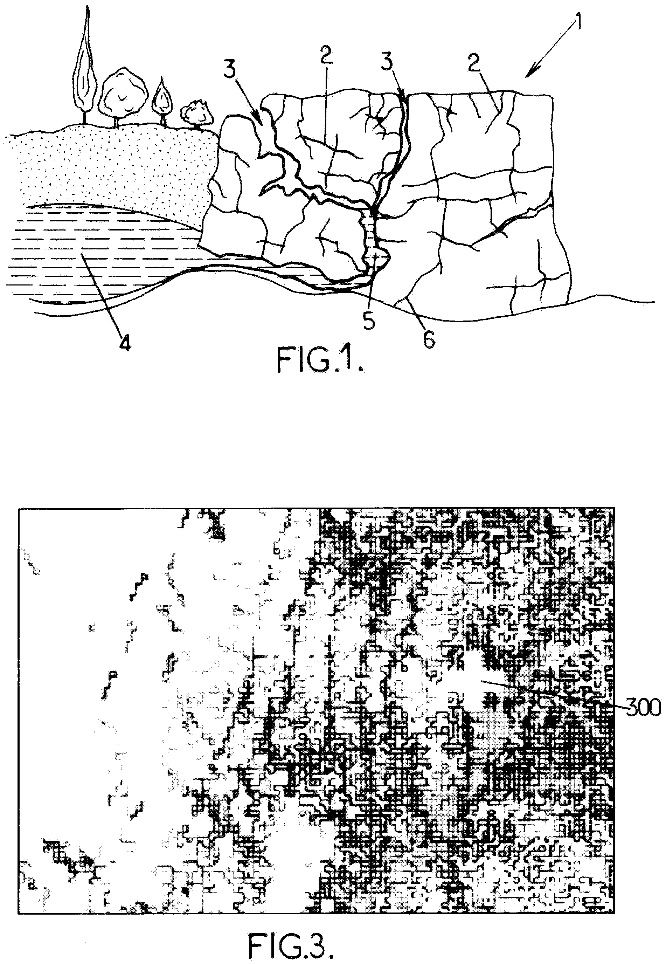

La figure 1 montre un exemple de zone karstique 1. Cette zone 1 comporte des fractures 2, 6, et des cavités 3, 5 dans une roche. Comme la zone 1 est en partie inondée, par exemple du fait de la proximité d'une nappe phréatique 4, les fractures 6 et les cavités 5 peuvent être remplies d'eau.

La roche peut par exemple comprendre du calcaire.

De l'eau de pluie, ou bien encore de l'eau provenant de la nappe phréatique ou de remontées hydrothermales, peut s'infiltrer à travers des interstices, par exemple les pores de la roche, les fractures 2, 6, et/ou les cavités 3, 5. Cette infiltration augmente la taille de ces interstices du fait de la dissolution de carbonates de la roche dans l'eau infiltrée, ce qui peut conduire à la formation de cavités.

Dans l'invention et dans les modes de réalisation représentés, on se propose de simuler ce phénomène de karstification par une approche gaz sur réseau. On définit un modèle géologique maillé de la région géologique. Des particules représentant des gouttes d'eau, des molécules d'eau, ou autre, sont introduites sur le maillage. On simule le déplacement stochastique de ces particules et le modèle évolue selon les déplacements de ces particules. On présume ici que les particules n'interagissent pas entre elles.

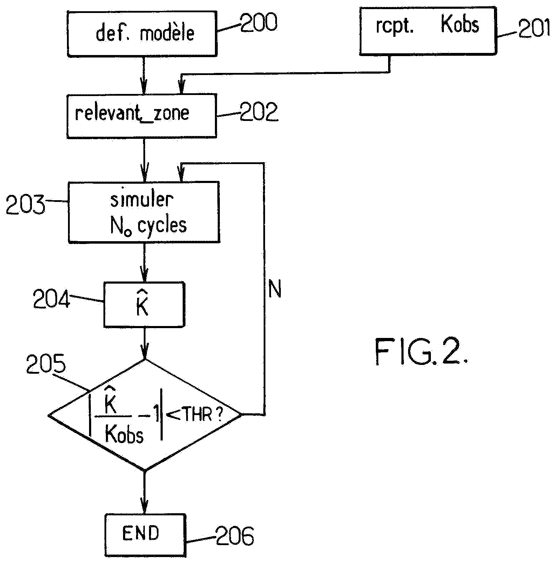

La figure 2 est un organigramme d'un exemple de procédé selon un mode de réalisation de l'invention.

Un modèle d'une région géologique existante est défini lors d'une étape 200. On définit un maillage représentant la région géologique. Le modèle géologique maillé peut être à deux dimensions, ou avantageusement à trois dimensions. Le modèle maillé ne se limite pas aux grilles de type boite à sucre (« sugarbox » en anglais). On peut par exemple prévoir des géométries de maille plus complexes.

La définition du modèle, bien que représentée de façon sommaire par une seule étape 200, peut conduire à fixer un certain nombre de paramètres.

Par exemple, lors de cette étape 200, on peut définir les dimensions associées à chaque maille, par exemple 100x100x5 mètres, et certaines propriétés de maille comme le faciès de la roche correspondant à chaque maille, la porosité, la perméabilité, ou autre.

Il est possible d'utiliser des informations obtenues de la région géologique existante, par exemple des carottes ou bien encore des données d'imagerie, fournissant des informations sur la zone karstique actuelle, par exemple des emplacements grossiers de couches géologiques, de failles, de fractures, de barrières imperméables, ou autre.

Un sous-échantillonnage (« rescaling » en anglais) peut également être effectué lors de l'étape 200, pour diminuer le nombre de mailles, de par exemple un facteur $5^3=125$ ou $10^3=1000$, de façon à limiter le temps de simulation.

Lors de l'étape 200, on peut en outre introduire des discontinuités de type fractures, de manière aléatoire, en utilisant par exemple un moteur de fracturation booléen. Un tel moteur peut être capable de prendre en compte le faciès de la roche, et de générer plusieurs familles de fractures, ces familles étant caractérisées par exemple par des densités de fractures, des géométries de fractures, des orientations de fractures, ou autre.

On peut également introduire des discontinuités de type litages ou joints de stratification (« beddings » en anglais).

On peut éventuellement prévoir des étapes non-représentées d'introduction d'autres discontinuités.

Un diamètre de conduit initial est affecté aux arêtes du maillage correspondant à ces discontinuités, lors d'une étape non représentée. On peut prévoir que les autres arêtes aient un diamètre nul.

Lors de cette étape 200, on peut en outre définir différentes phases de karstification. Par exemple, une phase peut correspondre à une période au cours de laquelle la roche est restée émergée avec un certain gradient hydraulique, puis une autre phase plus tardive à une autre période caractérisée par un autre gradient hydraulique, etc. A chaque phase correspond un ensemble de discontinuités parmi les discontinuités déjà définies.

Par exemple, on peut avoir défini des discontinuités d'orientation Nord-Sud et des discontinuités d'orientation Est-Ouest. Par exemple, à une première phase peut correspondre la moitié des discontinuités d'orientation Nord-Sud et aucune discontinuité d'orientation Est-Ouest, tandis qu'à une deuxième phase correspond la totalité des discontinuités.

On peut en outre définir pour chaque phase un index d'agressivité de l'eau IA indiquant la capacité de l'eau à dissoudre des carbonates, un gradient hydraulique, un niveau de zone saturée en eau, les zones d'infiltration et les zones saturées, une orientation de la roche, un nombre de cycles affectés à cette phase, un nombre de particules introduites à chaque cycle, des nœuds d'introduction de particules, ou autre.

Par ailleurs, lors d'une étape 201, on reçoit des observations d'un paramètre donné de la région géologique. Dans cet exemple, le paramètre observé est un paramètre de perméabilité $K_{obs}$, mais l'invention concerne également la porosité comme paramètre observé.

Lors d'une étape 202, on définit une zone du modèle géologique pour laquelle l'observation $K_{obs}$ est pertinente. On estime une sous-région de la région géologique pour laquelle cette observation $K_{obs}$ est pertinente. Par exemple, si l'observation est effectuée au niveau d'un puits, on peut considérer que pour un volume donné autour de ce puits, la perméabilité est suffisamment proche de $K_{obs}$, de sorte que la sous-région est constituée de ce volume. Le volume peut être par exemple un cylindre centré sur le puits et d'un rayon donné, par exemple 300 mètres. Les dimensions du volume peuvent être fixées par l'homme du métier. On détermine la zone du modèle correspondant à cette sous-région.

Lors d'une étape 203, on effectue une simulation des déplacements stochastiques de particules sur le maillage défini à l'étape 200.

Dans l'invention et dans cet exemple, on effectue une simulation sur un nombre de cycles $N_0$ choisi arbitrairement, par exemple 1000 cycles. A chaque cycle, et pour chaque particule, on calcule des probabilités de déplacement de la particule, à partir de valeurs de diamètre de conduit de l'arête du maillage correspondant à ce déplacement. Puis un tirage au sort est effectué, en tenant compte des probabilités calculées, et on choisit un déplacement en fonction du résultat du tirage au sort. On peut prévoir que chaque déplacement soit susceptible de combiner un déplacement advectif et un déplacement dispersif.

On pourra par exemple utiliser un procédé tel que décrit dans à l'article de O. Jaquet et al., mentionné plus haut. Chaque déplacement représente le passage d'une particule, et affecte le modèle. Par exemple, une valeur de perméabilité de maille dans la matrice, et/ou une valeur de diamètre de conduit dans les discontinuités, sont modifiées par le passage de la particule. Pour calculer les modifications, on peut par exemple prendre en compte un produit IKxIA, où IK est un index de karstification indicatif du potentiel de dissolution de la roche, et IA est un index d'agressivité de particule indicatif de la capacité de l'eau à dissoudre des carbonates.

Après $N_0$ cycles, on effectue une remise à l'échelle (« upscaling » en anglais) pour estimer une valeur de perméabilité $\hat{K}$ équivalente sur la zone pertinente.

On utilise un outil du type solveur de pression, qui peut être basé sur une résolution de l'équation de Darcy sur la zone pertinente.

Les valeurs $\hat{K}$ et $K_{obs}$ sont comparées l'une à l'autre lors d'une étape de test 205. Il appartient à l'homme du métier de fixer une valeur de seuil THR adéquate, éventuellement en procédant de manière empirique.

La simulation est poursuivie tant que ces valeurs sont relativement éloignées l'une de l'autre. On peut optionnellement prévoir une étape de test non représentée qui permettrait de mettre fin à la simulation quand le total du nombre de cycles simulés atteint un seuil maximum, afin d'assurer une sortie de boucle.

En revanche, lorsque les valeurs $\hat{K}$ et $K_{obs}$ sont suffisamment proches l'une de l'autre, il est mis fin à la simulation. On peut alors effectuer une mise à l'échelle (étape non représentée).

Ainsi, avec un tel calibrage, on a fait évoluer le modèle jusqu'à un calage relatif à l'observation $K_{obs}$. L'observation de données réelles est utilisée pour choisir de façon judicieuse quand mettre fin à la simulation.

La figure 3 montre un exemple d'image susceptible d'être obtenue par un procédé selon un mode de réalisation de l'invention.

Dans ce mode de réalisation, si la comparaison entre le paramètre observé et le paramètre estimé montre que ces valeurs sont suffisamment proches, il est mis fin à la simulation seulement sur la zone pertinente définie, ici la zone en forme de croix 300.

Les traits sur l'image représentent des conduits dont le diamètre est supérieur à un seuil. Au fur et à mesure de la simulation, les particules se déplacent sur le maillage et ces déplacements augmentent le diamètre des conduits empruntés. Aussi le nombre de conduits dont le diamètre est supérieur au seuil augmente-il avec le nombre de cycles simulés.

Dans cet exemple, il a été mis fin à la simulation sur la zone 300 relativement tôt, de sorte qu'aucun trait n'apparaît sur cette zone.

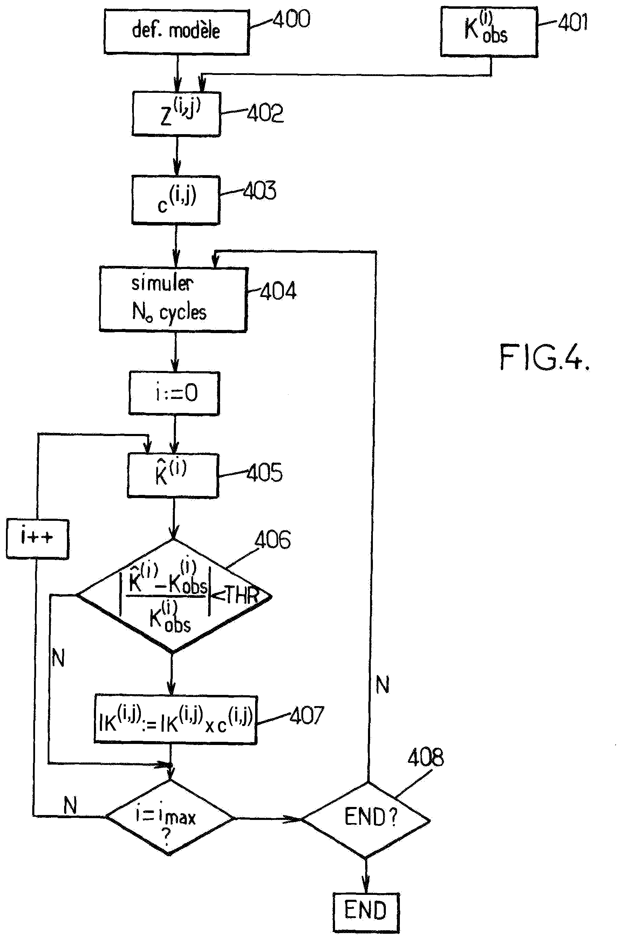

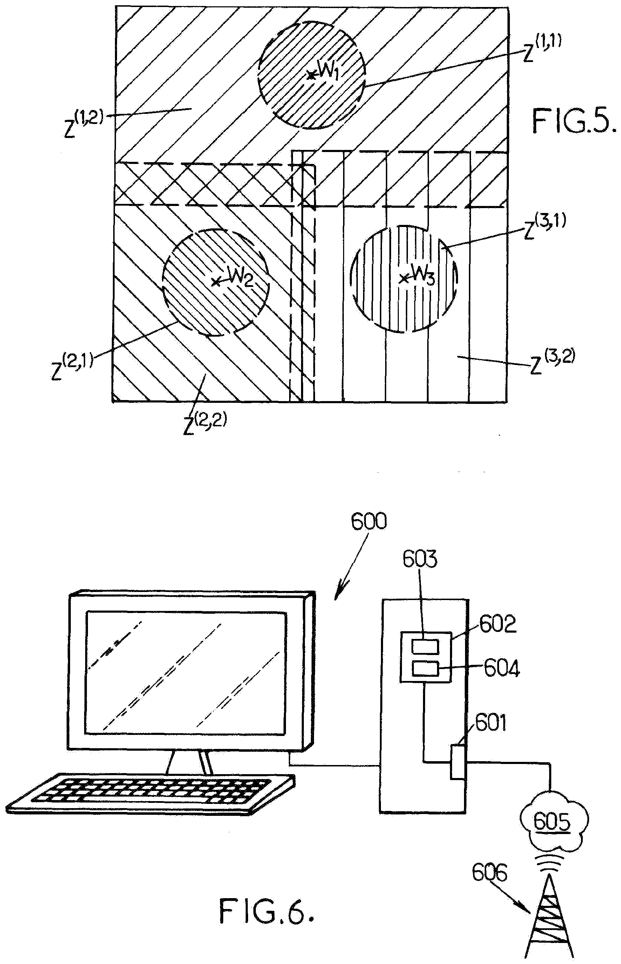

Les figures 4 et 5 sont relatives à un mode de réalisation dans lequel on cherche à éviter de tels contrastes entre la zone pertinente et le reste du modèle.

Le procédé de la figure 4 comporte une étape de définition de modèle 400, et une étape 401 de réception de par exemple trois observations $K_{obs}^{(i)}$. Ces observations peuvent par exemple être obtenues par des essais de puits (« well test » en anglais).

Pour chaque observation $K_{obs}^{(i)}$ de la perméabilité, on définit à l'étape 402 une zone de représentativité $Z^{(i,1)}$, ou zone pertinente, pour laquelle l'observation $K_{obs}^{(i)}$ est pertinente. On définit également une zone de représentativité supplémentaire $Z^{(i,2)}$, ou zone d'influence.

Des exemples de zones $Z^{(i,1)}$ et $Z^{(i,2)}$ sont montrés à la figure 5. Dans cet exemple, les observations sont mesurées au niveau de puits représentés sur le modèle par les références $W_1$, $W_2$, $W_3$. Les zones pertinentes $Z^{(i,1)}$ correspondent aux mailles dans un certain rayon autour des modélisations des puits. Ce rayon peut correspondre à une distance de 300 mètres par exemple. Les limites des zones d'influence $Z^{(i,2)}$ peuvent par exemple être choisies arbitrairement, afin que l'ensemble des zones définies recouvre la totalité du modèle. Dans cet exemple, on observe un recoupement possible des zones d'influence $Z^{(i,2)}$.

Pour revenir à la figure 4, on associe lors d'une étape 403 à chaque zone de représentativité $Z^{(i,j)}$ une valeur de paramètre de simulation, par exemple un coefficient $c^{(i,i)}$ pour pondérer des valeurs d'index de karstification IK correspondant à cette zone.

On peut prévoir une seule valeur d'index de karstification IK par zone, ou bien davantage. Par exemple, on peut prévoir une valeur d'index de karstification IK par maille.

Par exemple, pour les zones pertinentes $Z^{(i,1)}$, $c^{(i,1)} = 0$, et pour les zones d'influence, $c^{(i,2)} = 0,5$.

Puis $N_0$ cycles de simulation sont effectués lors d'une étape 404, avec des index de karstification initialement non pondérés par les coefficients $c^{(i,j)}$. Lors d'une étape 405, on estime pour chaque puits une valeur équi-

valente de perméabilité $\hat{K}^{(i)}$ sur la zone pertinente $Z^{(i,1)}$ correspondant à ce puits, en effectuant par exemple une remise à l'échelle.

Une comparaison avec la valeur observée correspondante $K_{obs}^{(i)}$ est menée lors d'une étape 406. Si la comparaison montre que les valeurs $K_{obs}^{(i)}$ et $\hat{K}^{(i)}$ sont relativement éloignées l'une de l'autre, alors les valeurs d'index de karstification IK$^{(i,1)}$, IK$^{(i,2)}$ correspondant aux zones $Z^{(i,1)}$ et $Z^{(i,2)}$ restent non pondérées.

En revanche, si la comparaison montre que les valeurs $K_{obs}^{(i)}$ et $\hat{K}^{(i)}$ sont suffisamment l'une de l'autre, une étape 407 est effectuée au cours de laquelle :

- la ou les valeurs d'index de karstification IK$^{(i,1)}$ correspondant à la zone pertinente $Z^{(i,1)}$ est (sont) pondérée (s) par le coefficient $c^{(i,1)} = 0$. Ainsi, la simulation ne produit plus d'effet pour la zone pertinente $Z^{(i,l)}$. On peut alors prévoir de mettre fin à la simulation pour la zone pertinente $Z^{(i,1)}$.
- la ou les valeurs d'index de karstification IK$^{(i,2)}$ correspondant à la zone d'influence $Z^{(i,2)}$ est (sont) pondérée (s) par le coefficient $c^{(i,2)} = 0,5$. Dit autrement, la simulation pour la zone d'influence $Z^{(i,2)}$ peut se poursuivre, mais avec une efficacité deux fois moindre.

Ainsi, pour atténuer les effets de la simulation, on pondère les index IK, et donc les produits IKxIA, de façon à limiter les conséquences des déplacements de particules sur les paramètres du modèle, par exemple les diamètres de conduit. On considère qu'il est mis fin à la simulation lorsque les déplacements de particules ont un effet nul sur les paramètres du modèle du type diamètre de conduit ou perméabilité.

Les étapes 405, 406 et 407 sont effectuées pour chacune des observations $K_{obs}^{(i)}$. Une boucle parcourant ces trois observations peut être mise en place, avec les étapes classiques d'initialisation, de test, et d'incrémentation.

Ainsi, si le test 406 est positif pour plusieurs observations, les parties $Z^{(i,2)} \cap Z^{(i',2)}$ du modèle correspondant à des recoupements de plusieurs zones d'influence voient leur nombre moyen de particules à introduire par cycle et par maille de surface pondéré et par $c^{(i,2)}$, et par $c^{(i',2)}$.

Une fois les étapes 405, 406 et 407 effectuées pour chacune des observations $K_{obs}^{(i)}$, on vérifie lors d'une étape 408 qu'il existe bien une observation pour laquelle le test 406 a été négatif. Dans ce cas, la simulation reprend, avec, pour chaque observation pour laquelle le test 406 a été positif, des zones pour lesquelles la simulation est arrêtée, ou atténuée dans ses effets, ou privée d'effets.

Si le test 408 montre que le test 406 est positif pour toutes les observations, alors il est mis fin à la simulation.

Dans une variante de réalisation, les coefficients de pondération $c^{(i,i)}$ pondèrent non pas l'index de karstification, mais un nombre de particules à introduire sur le réseau par cycle et par maille de surface du modèle. Dans cette variante, on peut prévoir d'éliminer avant chaque ensemble de $N_0$ cycles de simulation les particules éventuellement présentes dans le modèle.

Dans une autre variante de réalisation, les coefficients de pondération $c^{(i,i)}$ modulent le nombre de cycles $N_0$ à effectuer pour une partie du modèle donné. On peut ainsi prévoir une simulation normale sur une partie du modèle, et une absence de déplacement par exemple un cycle sur deux sur une zone d'influence.

Le paramètre de simulation peut alternativement comprendre un nombre de cycles à exécuter avant la prochaine comparaison entre valeurs estimées et valeurs mesurées.

L'invention n'est en rien limitée par la façon dont on adapte les effets de la simulation.

Dans une autre variante de réalisation, les observations peuvent comprendre des mesures effectuées le long de puits, à des profondeurs variables. Pour chaque puits, et pour chaque observation correspondant à un intervalle de profondeur donné, on définit une zone pertinente. On peut par exemple définir des zones pertinentes cylindriques le long du puits, à des profondeurs diverses. Pour chaque zone pertinente, on estime à partir du modèle simulé, une estimation du paramètre observé. Si ce paramètre observé est suffisamment proche du paramètre estimé, il est mis fin à la simulation sur la zone pertinente.

Est représenté sur la figure 6 un exemple de dispositif de simulation 600. Dans ce mode de réalisation, le dispositif comporte un ordinateur 600, comprenant des moyens de réception 601 agencés pour recevoir une observation d'un paramètre donné de la région géologique, par exemple un modem 601 relié à un réseau 605 lui-même en communication avec un puits 606. Le dispositif 600 comporte en outre une mémoire non représentée pour stocker le modèle géologique maillé. Des moyens de traitement, par exemple un processeur 602, comportent des moyens de comparaison 603 pour exécuter l'étape 205 de la figure 2, et des moyens de simulation 604 des déplacements stochastiques de particules sur le modèle stocké dans la mémoire. Les moyens de traitement 602 sont par exemple aptes à exécuter les étapes 200, 202, 204 et 206 de la figure 2.

**Revendications**

1. Procédé de simulation, mis en œuvre par un dispositif de simulation, d'un phénomène géologique de karstification ayant conduit à la formation d'une région géologique, comprenant les étapes suivantes :

a/ définir (200) un modèle maillé de la région géologique,

b/ recevoir (201) une observation ($K_{obs}$) d'un paramètre de perméabilité ou de porosité donné de la région géologique mesurée au niveau d'un puits,

c/ définir (202) une zone du modèle, dite zone pertinente, ladite zone pertinente correspondant à une zone ayant un rayon autour dudit puits,

d/ simuler (203) le phénomène géologique à partir du modèle de la région géologique défini à l'étape a/, la simulation comprenant N0 itérations d'un déplacement stochastique de particule d'eau dans le modèle, le modèle évoluant selon le déplacement de ces particules, le déplacement étant fonction d'un diamètre de conduit associé à une arête correspondant à ce déplacement,

e/ après les N0 itérations, estimer (204) la valeur du paramètre de perméabilité ou de porosité donné pour la zone pertinente du modèle définie à l'étape c/ en utilisant un solveur de pression, et en utilisant les résultats de la simulation,

f/ comparer (205) l'observation ($K_{obs}$) du paramètre donné reçue à l'étape b/ avec l'estimation ($\hat{K}$) dudit paramètre obtenue à l'étape e/, et

g/ selon les résultats de la comparaison de l'étape f/, modifier un paramètre de simulation pour adapter les effets de la simulation sur seulement une zone du modèle ;

h/ obtenir une image sur la base des étapes a/ à g/.

2. Procédé de simulation selon la revendication 1, dans lequel, à l'étape g/, il est mis fin à la simulation si les résultats de la comparaison de l'étape f/ montrent que l'observation et l'estimation du paramètre donné sont suffisamment proches.

3. Procédé de simulation selon l'une des revendications 1 ou 2, dans lequel, à l'étape g/, le paramètre de simulation est modifié de façon à atténuer les effets de la simulation sur ladite au moins une partie du modèle.

4. Procédé de simulation selon l'une des revendications 1 à 3, dans lequel,
à l'étape b/, on reçoit plusieurs observations ($K_{obs}^{(i)}$), les étapes c/, e/ et f/ étant effectuées pour chacune des observations reçues.

5. Procédé de simulation selon la revendication 4, dans lequel on définit pour chaque observation ($K_{obs}^{(i)}$) une zone de représentativité ($Z^{(i,1)}$) de l'observation, et

à l'étape g/, pour chaque zone de représentativité, on modifie le paramètre de simulation correspondant à ladite zone, selon le résultat de la comparaison entre l'observation correspondant à cette zone et l'estimation correspondant à cette zone.

6. Procédé de simulation selon la revendication 5, dans lequel, pour au moins une observation,

on définit au moins une zone de représentativité supplémentaire ($Z^{(i,2)}$),
on associe à chacune des dites zones de représentativité supplémentaires une valeur de paramètre de simulation supplémentaire ($c^{(i,2)}$),
et lors de l'étape g/, selon les résultats de la comparaison de l'étape f/, on modifie en outre au moins ledit paramètre de simulation supplémentaire de façon à adapter les effets de la simulation sur ladite au moins une zone de représentativité supplémentaire.

7. Produit programme d'ordinateur de simulation d'un phénomène géologique de karstification ayant conduit à la formation d'une région géologique, le programme d'ordinateur étant destiné à être stocké dans une mémoire d'une unité centrale, et/ou stocké sur un support mémoire destiné à coopérer avec un lecteur de ladite unité centrale et/ou téléchargé via un réseau de télécommunication, **caractérisé en ce qu'**il comprend des instructions pour :

a/ définir un modèle maillé de la région géologique,
b/ recevoir une observation d'un paramètre de perméabilité ou de porosité donné de la région géologique mesurée au niveau d'un puits,
c/ définir une zone du modèle, dite zone pertinente, ladite zone pertinente correspondant à une zone ayant un rayon autour dudit puits,
d/ simuler le phénomène géologique à partir du modèle de la région géologique, la simulation comprenant N0 itérations d'un déplacement stochastique de particule d'eau dans le modèle, le modèle évoluant selon le déplacement de ces particules, le déplacement étant fonction d'un diamètre de conduit associé à une arête correspondant à ce déplacement,
e/ après les N0 itérations, estimer la valeur du paramètre de perméabilité ou de porosité donné pour la zone pertinente du modèle en utilisant un solveur de pression, et en utilisant les résultats de la simulation,
f/ comparer l'observation du paramètre donné reçue avec l'estimation dudit paramètre, et
g/ selon les résultats de la comparaison, modifier un paramètre de simulation pour adapter les effets de la simulation seulement sur une partie du modèle ;

h/ obtenir une image sur la base des étapes a/ à g/.

**8.** Dispositif (600) de simulation d'un phénomène géologique de karstification ayant conduit à la formation d'une région géologique, ledit dispositif comportant

des moyens de réception (601) agencés pour b/ recevoir une observation d'un paramètre de perméabilité ou de porosité donné de la région géologique mesurée au niveau d'un puits, des moyens de traitement (602) agencés pour

c/ définir un modèle maillé de la région géologique,

définir une zone du modèle, dite zone pertinente, ladite zone pertinente correspondant à une zone ayant un rayon autour dudit puits,

d/ simuler le phénomène géologique à partir du modèle de la région géologique, la simulation comprenant N0 itérations d'un déplacement stochastique de particule d'eau dans le modèle, le modèle évoluant selon le déplacement de ces particules, le déplacement étant fonction d'un diamètre de conduit associé à une arête correspondant à ce déplacement, et

e/ après les N0 itérations, estimer la valeur du paramètre de perméabilité ou de porosité donné pour la zone pertinente du modèle en utilisant un solveur de pression, en utilisant les résultats de la simulation,

des moyens de comparaison (603) agencés pour

f/ comparer l'observation du paramètre donné reçue des moyens de réception avec l'estimation dudit paramètre obtenue par les moyens de traitement,

et dans lequel les moyens de traitement sont agencés pour

g/ modifier un paramètre de simulation de façon à adapter les effets de la simulation sur seulement une partie du modèle suite à la réception d'un signal provenant des moyens de comparaison

et dans lequel les moyens de traitement sont agencés pour obtenir une image sur la base des opérations effectuées par les moyens de traitement pour les étapes b/ à g/.

**Patentansprüche**

**1.** Verfahren zur Simulation eines geologischen Verkarstungsphänomens, das zur Bildung einer geologischen Region geführt hat, durch eine Simulationsvorrichtung, umfassend die folgenden Schritte:

a/ Definieren (200) eines Gittermodells der geologischen Region,
b/ Empfangen (201) einer Beobachtung ($K_{obs}$) eines gegebenen Permeabilitäts- oder Porositätsparameters der geologischen Region, der an einem Bohrloch gemessen wurde,
c/ Definieren (202) eines Bereichs des Modells, der als relevanter Bereich bezeichnet wird, wobei der relevante Bereich einem Bereich mit einem Radius um das Bohrloch entspricht,
d/ Simulieren (203) des geologischen Phänomens anhand des in Schritt a/ definierten Modells der geologischen Region, wobei die Simulation N0 Iterationen einer stochastischen Verschiebung von Wasserpartikeln in dem Modell umfasst, wobei sich das Modell entsprechend der Verschiebung dieser Partikel entwickelt, wobei die Verschiebung eine Funktion eines Durchmessers der Leitung ist, der mit einem Bereich verbunden ist, der dieser Verschiebung entspricht,
e/ nach den N0 Iterationen, Schätzen (204) des Wertes des gegebenen Permeabilitäts- oder Porositätsparameters für den relevanten Bereich des Modells, der in Schritt c/ definiert wurde, unter Verwendung eines Drucklösers und unter Verwendung der Simulationsergebnisse,
f/ Vergleichen (205) der Beobachtung ($K_{obs}$) des in Schritt b/ erhaltenen gegebenen Parameters mit der in Schritt e/ erhaltenen Schätzung ($\hat{K}$) des Parameters, und
g/ entsprechend den Ergebnissen des Vergleichs in Schritt f/, Modifizieren eines Simulationsparameters, um die Auswirkungen der Simulation auf nur einen Bereich des Modells anzupassen;
h/ Erhalten eines Bildes auf der Grundlage der Schritte a/ bis g/.

**2.** Simulationsverfahren nach Anspruch 1, wobei in Schritt g/ die Simulation beendet wird, wenn die Ergebnisse des Vergleichs in Schritt f/ zeigen, dass die Beobachtung und die Schätzung des gegebenen Parameters hinreichend nahe beieinander liegen.

**3.** Simulationsverfahren nach einem der Ansprüche 1 oder 2, wobei in Schritt g/ der Simulationsparameter so modifiziert wird, dass die Auswirkungen der Simulation auf den wenigstens einen Teil des Modells abgeschwächt werden.

**4.** Simulationsverfahren nach einem der Ansprüche 1 bis 3, wobei,

in Schritt b/ mehrere Beobachtungen $\left(K_{obs}^{(i)}\right)$ emp-

fangen werden, wobei die Schritte c/, e/ und f/ für jede der empfangenen Beobachtungen durchgeführt werden.

5. Simulationsverfahren nach Anspruch 4, wobei für jede Beobachtung $\left(K_{obs}^{(i)}\right)$ ein repräsentativer Bereich $(Z^{(i,l)})$ der Beobachtung definiert wird, und in Schritt g/ für jeden Repräsentativitätsbereich der Simulationsparameter, der diesem Bereich entspricht, entsprechend dem Ergebnis des Vergleichs zwischen der Beobachtung, die diesem Bereich entspricht, und der Schätzung, die diesem Bereich entspricht, geändert wird.

6. Simulationsverfahren nach Anspruch 5, wobei für wenigstens eine Beobachtung wenigstens ein zusätzlicher Repräsentativitätsbereich $(Z^{(i,2)})$ definiert wird, jedem der genannten zusätzlichen Repräsentativitätsbereiche ein Wert eines zusätzlichen Simulationsparameters $(c^{(i,2)})$ zugeordnet wird, und in Schritt g/, abhängig von den Ergebnissen des Vergleichs in Schritt f/, wenigstens der zusätzliche Simulationsparameter weiter modifiziert wird, um die Auswirkungen der Simulation auf den wenigstens einen zusätzlichen Repräsentativitätsbereich anzupassen.

7. Computerprogrammprodukt zur Simulation eines geologischen Verkarstungsphänomens, das zur Bildung einer geologischen Region geführt hat, wobei das Computerprogramm dazu bestimmt ist, in einem Speicher einer Zentraleinheit gespeichert zu werden und/oder auf einem Speichermedium gespeichert zu werden, das dazu bestimmt ist, mit einem Laufwerk der Zentraleinheit zusammenzuarbeiten und/oder über ein zentrales Telekommunikationsnetz heruntergeladen zu werden, **dadurch gekennzeichnet, dass** es Anweisungen umfasst zum:

a/ Definieren eines Gittermodells der geologischen Region,
b/ Empfangen einer Beobachtung eines bestimmten Permeabilitäts- oder Porositätsparameters der geologischen Region, der an einem Bohrloch gemessen wurde,
c/ Definieren eines Bereichs des Modells, der als relevanter Bereich bezeichnet wird, wobei der relevante Bereich einem Bereich mit einem Radius um das Bohrloch entspricht,
d/ Simulieren des geologischen Phänomens anhand des Modells der geologischen Region, wobei die Simulation N0 Iterationen einer stochastischen Verschiebung von Wasserpartikeln in dem Modell umfasst, wobei sich das Modell entsprechend der Verschiebung dieser Partikel entwickelt, wobei die Verschiebung eine Funktion eines Durchmessers derLeitung ist, der mit einem Bereich verbunden ist, der dieser Verschiebung entspricht,
e/ nach den NO Iterationen Schätzen des Wertes des gegebenen Permeabilitäts- oder Porositätsparameters für den relevanten Bereich des Modells unter Verwendung eines Drucklösers und unter Verwendung der Simulationsergebnisse,
f/ Vergleichen der Beobachtung des erhaltenen gegebenen Parameters mit der Schätzung dieses Parameters, und
g/ Modifizieren eines Simulationsparameters gemäß den Ergebnissen des Vergleichs, um die Auswirkungen der Simulation nur auf einen Teil des Modells anzupassen;
h/ Erhalten eines Bildes auf der Grundlage der Schritte a/ bis g/.

8. Vorrichtung (600) zur Simulation eines geologischen Phänomens der Verkarstung, das zur Bildung einer geologischen Region geführt hat, wobei die Vorrichtung Empfangsmittel (601) umfasst, die dazu angeordnet sind,

b/ eine Beobachtung eines gegebenen Permeabilitäts- oder Porositätsparameters der an einem Bohrloch gemessenen geologischen Region zu empfangen,
Verarbeitungsmittel (602), die dazu angeordnet sind,
c/ ein Gittermodell der geologischen Region zu definieren, einen Bereich des Modells zu definieren, der als relevanter Bereich bezeichnet wird, wobei der relevante Bereich einem Bereich mit einem Radius um das Bohrloch entspricht,
d/ das geologische Phänomen anhand des Modells der geologischen Region zu simulieren, wobei die Simulation N0 Iterationen einer stochastischen Verschiebung von Wasserpartikeln in dem Modell umfasst, wobei sich das Modell entsprechend der Verschiebung dieser Partikel entwickelt, wobei die Verschiebung eine Funktion eines Durchmessers der Leitung ist, die mit einem Bereich verbunden ist, der dieser Verschiebung entspricht, und
e/ nach den N0 Iterationen, Schätzen des Wertes des gegebenen Permeabilitäts- oder Porositätsparameters für den relevanten Bereich des Modells unter Verwendung eines Drucklösers unter Verwendung der Ergebnisse der Simulation,
Vergleichsmittel (603), die dazu angeordnet sind,
f/ die Beobachtung des der von den Empfangsmitteln erhaltenen gegebenen Parameters mit der Schätzung des Parameters, die von den Verarbeitungsmitteln erhalten wurde, zu vergleichen,
und wobei die Verarbeitungsmittel dazu angeordnet sind,

g/ einen Simulationsparameter so zu modifizieren, dass die Auswirkungen der Simulation auf nur einen Teil des Modells nach dem Empfang eines Signals von den Vergleichsmitteln angepasst werden, und

wobei die Verarbeitungsmittel dazu angeordnet sind, auf der Grundlage der von der Verarbeitungseinrichtung für die Schritte b/ bis g/ durchgeführten Operationen ein Bild zu erhalten.

**Claims**

1.  Method for simulating, implemented by a simulation device, a geological phenomenon of karstification which resulted in the formation of a geological region, comprising the following steps:

    a/ defining (200) a gridded model of the geological region,
    b/ receiving (201) an observation ($K_{obs}$) of a given parameter of permeability or porosity of the geological region measured at a well,
    c/ defining (202) a zone of the model, called relevant zone, said relevant zone corresponding to a zone having a radius around said well,
    d/ simulating (203) the geological phenomenon based on the model of the geological region defined in step a/, the simulation comprising No iterations of a stochastic displacement of a water particle in the model, the model evolving according to the displacement of these particles, the displacement being a function of a conduit diameter associated with an edge corresponding to this displacement,
    e/ after the $N_0$ iterations, estimating (204) the value of the given parameter of permeability or porosity for the relevant zone of the model defined in step c/ using a pressure solver, and using the results of the simulation,
    f/ comparing (205) the observation ($K_{obs}$) of the given parameter received in step b/ with the estimate ($\hat{K}$) of said parameter obtained in step e/, and
    g/ based on the results of the comparison in step f/, modifying a simulation parameter to adjust the effects of the simulation for only a zone of the model.
    h/ obtain an image based on steps a/ to g/.

2.  Simulation method according to claim 1, wherein, in step g/, the simulation is ended if the results of the comparison in step f/ show that the observation and the estimate for the given parameter are sufficiently close.

3.  Simulation method according to either of claims 1 or 2, wherein, in step g/, the simulation parameter is modified in a manner that attenuates the effects of the simulation on said at least a portion of the model.

4.  Simulation method according to any one of claims 1 to 3, wherein,

    in step b/, multiple observations ($K_{obs}^{(i)}$) are received, the steps c/, e/ and f/ being performed for each of the observations received.

5.  Simulation method according to claim 4, wherein for

    each observation ($K_{obs}^{(i)}$), a representative zone ($Z^{(i,1)}$) for the observation is defined, and
    in step g/, for each representative zone, the simulation parameter corresponding to said zone is modified based on the result of the comparison between the observation corresponding to this zone and the estimate corresponding to this zone.

6.  Simulation method according to claim 5, wherein, for at least one observation,

    at least one supplemental representative zone ($Z^{(i,2)}$) is defined,
    each of said supplemental representative zones being associated with a supplemental simulation parameter value ($c^{(i,2)}$),
    and during step g/, depending on the results of the comparison in step f/, at least said supplemental simulation parameter is additionally modified so as to adjust the effects of the simulation for said at least one supplemental representative zone.

7.  Computer program product for simulating a geological phenomenon of karstification which resulted in the formation of a geological region, said computer program being intended to be stored in the memory of a computing device and/or stored on a storage medium intended to cooperate with a reader of said computing device and/or downloaded via a telecommunication network, wherein said computer program comprises instructions for:

    a/ defining a gridded model of the geological region,
    b/ receiving an observation of a given parameter of permeability or porosity of the geological region measured at a well,
    c/ defining a zone of the model, called relevant zone, said relevant zone corresponding to a zone having a radius around said well,
    d/ simulating the geological phenomenon based on the model of the geological region, the simulation comprising $N_O$ iterations of a stochastic displacement of a water particle in the model, the model evolving according to the displacement of these particles, the displacement being a function of a conduit diameter associated with an edge corresponding to this displacement,

e/ after the $N_0$ iterations, estimating the value of the given parameter of permeability or porosity for the relevant zone of the model using a pressure solver, and using the results of the simulation,

f/ comparing the observation of the given parameter received with the estimate of said parameter, and

g/ depending on the results of the comparison, modifying a simulation parameter to adjust the effects of the simulation for only a zone of the model.

h/ obtain an image based on steps a/ to g/.

8. Simulation device (600) for simulating a geological phenomenon of karstification which resulted in the formation of a geological region, said device comprising

a receiving means (601) for b/ receiving an observation of a given parameter of permeability or porosity of the geological region measured at a well,

a processing means (602) for

c/ defining a gridded model of the geological region,

defining a zone of the model, called relevant zone, said relevant zone corresponding to a zone having a radius around said well,

d/ simulating the geological phenomenon based on the model of the geological region, the simulation comprising No iterations of a stochastic displacement of a water particle in the model, the model evolving according to the displacement of these particles, the displacement being a function of a conduit diameter associated with an edge corresponding to this displacement, and

e/ after the $N_0$ iterations, estimating the value of the given parameter of permeability or porosity for the relevant zone of the model using a pressure solver, and using the results of the simulation,

a comparison means (603) for f/ comparing the observation of the given parameter received from the receiving means with the estimate of said parameter obtained by the processing means,

and wherein the processing means is arranged to g/ modify a simulation parameter in a manner that adjusts the effects of the simulation for only a zone of the model after receiving a signal from the comparison means,

and wherein the processing means is arranged to obtain an image based on the operations performed by the processing means for steps b/ to g/.

FIG.1.

FIG.3.

EP 2 622 386 B1

def. modèle —200

rcpt.   Kobs —201

relevant_zone —202

203— simuler
N₀ cycles

204— $\hat{K}$

205 $\left|\dfrac{\hat{K}}{Kobs} - 1\right| < THR?$

N

FIG.2.

END —206

13

FIG.4.

FIG.5.

FIG.6.

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2002120429 A1
- US 6205402 B1
- US 6480790 B1
- US 2007156341 A1

**Littérature non-brevet citée dans la description**

- **O.JAQUET et al.** Stochastic discrete model of karstic networks. *Advances in Water Resources,* 2004, vol. 27, 751-760